# EUROPEAN PATENT APPLICATION

(11) **EP 4 029 970 A1**
(43) Date of publication of application: **20.07.2022**
(21) Application number: 20862066.6
(22) Date of filing: 11.09.2020
(51) Int. Cl.: C23C 18/16, C23C 18/20, C23C 18/31, C23C 18/52, H05K 1/02

(54) **MOLDED CIRCUIT COMPONENT AND ELECTRONIC DEVICE**

(30) Priority: 13.09.2019 JP 2019166902
(71) Applicant: Zefa Co., Ltd., Sukagawa-shi Fukushima 962-0001 (JP)
(72) Inventor: IDO, Takanori, Saitama-shi, Saitama 331-0815 (JP)
(74) Representative: Kador & Partner PartG mbB
(86) International application number: PCT/JP2020/034488
(87) International publication number: WO 2021/049624

(57) **Abstract**

Provided is a molded circuit component 300 in which a metal layer 200 is formed with high adhesion by giving a degree of freedom to a base material 100. In the molded circuit component 300 in which the metal layer 200 is formed in a processing region 110 in the base material 100, a plurality of recesses 120 each having a plurality of holes 130 are continuously formed in the processing region 110, the processing region 110 has a ratio of a width to a maximum depth with respect to a surface of the base material 100 of 10:1 to 6:1, the processing region 110 is formed to have a width in a range of 20 µm to 200 µm, and formed to have a maximum depth with respect to the surface of the base material 100 in a range of 2 µm to 30 µm, the metal layer 200 can be formed in the processing region 110 by laminating using a plating method, and a catalyst that reacts with a metal that forms the metal layer 200 at the time of the lamination is attached to the holes 130 and the recesses 120.

## Description

### Technical Field

The present invention relates to a molded circuit component and an electronic device, and particularly to various molded circuit components and electronic devices having electronic circuits such as electrical appliances, communication terminals, adapters for memory cards, optical receptacles, optical element blocks, electrical connectors, and automobiles.

### Background Art

Patent Literature 1 discloses an adapter for a memory card having an antenna circuit. In this antenna circuit, a base can be formed of a three-dimensional molded circuit component (MID) formed by conductive plating, and a shape of the adapter body can be appropriately designed according to a type of memory card by forming a part or the whole of the adapter body with the three-dimensional molded circuit component.

Patent Literature 1: JP 2006-318217 A

### Summary of Invention

### Technical Problem

However, Patent Literature 1 does not disclose any specific content of the molded circuit component, and how the molded circuit component is configured and what structure the molded circuit component has cannot be learned from Patent Literature 1. Furthermore, the degree of performance of the molded circuit component cannot be ascertained from Patent Literature 1.

An object of the present invention is to provide a molded circuit component in which a metal layer is formed with high adhesion by giving a degree of freedom to a base material.

In addition, an object of the present invention is to provide various electronic devices having electronic circuits such as electrical appliances, communication terminals, adapters for memory cards, optical receptacles, optical element blocks, electrical connectors, and automobiles, including this type of molded circuit component.

### Solution to Problem

In order to achieve the above objects, according to the present invention,
there is provided a molded circuit component including a metal layer formed in a processing region of a base material,
in which a plurality of recesses each having a plurality of holes are continuously formed in the processing region.

The processing region may have a ratio of a width to a maximum depth with respect to a surface of the base material of 10:1 to 6:1.

The processing region may be formed to have a width in a range of 20 µm to 200 µm, and formed to have a maximum depth with respect to the surface of the base material in a range of 2 µm to 30 µm.

The metal layer may be formed in the processing region by laminating using a plating method, and in this case, a catalyst that reacts with a metal that forms the metal layer at the time of the lamination may be attached to the holes and the recesses.

The molded circuit component according to claim 1, wherein a distance between centers of recesses adjacent to each other among the plurality of recesses is 0.01 mm to 0.2 mm.

A material that does not contain a metal material may be used in the base material.

An electronic device of the present invention includes the molded circuit component described above.

### Brief Description of Drawings

Fig. 1 is an external view of a molded circuit component 300 according to an embodiment of the present invention.
Fig. 2 is a manufacturing process diagram of the molded circuit component 300 illustrated in Fig. 1.
Fig. 3 is a manufacturing process diagram of the molded circuit component 300 illustrated in Fig. 1.
Fig. 4 is an explanatory view of forming a metal layer 200 with a high degree of adhesion to a base material 100 illustrated in Fig. 1.
Fig. 5 is SEM photographs of a side surface of a recess 120 constituting a hatch line 140 illustrated in Fig. 3(e).
Fig. 6 is SEM photographs illustrating a plane of a processing region 110 illustrated in Fig. 3(g).
Fig. 7 is SEM photographs illustrating a plane of the metal layer 200 in Fig. 1.
Fig. 8 is SEM photographs of a cross section of the metal layer 200 in Fig. 1.

### Reference Signs List

- 100: Base material
- 110: Processing region
- 120: Recess
- 130: Hole
- 140: Hatch line
- 150: Outline
- 200: Metal layer
- 300: Molded circuit component

### Description of Embodiments

Hereinafter, embodiments of the present invention will be described with reference to the drawings. It should be noted that, in the drawings, there are portions drawn with dimensions and the like different from actual dimensions and the like for easy understanding of the invention.

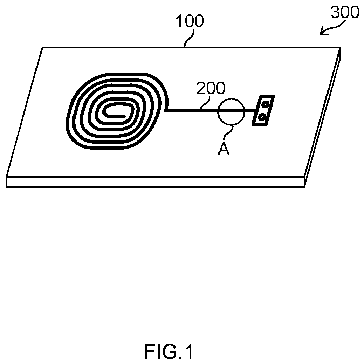

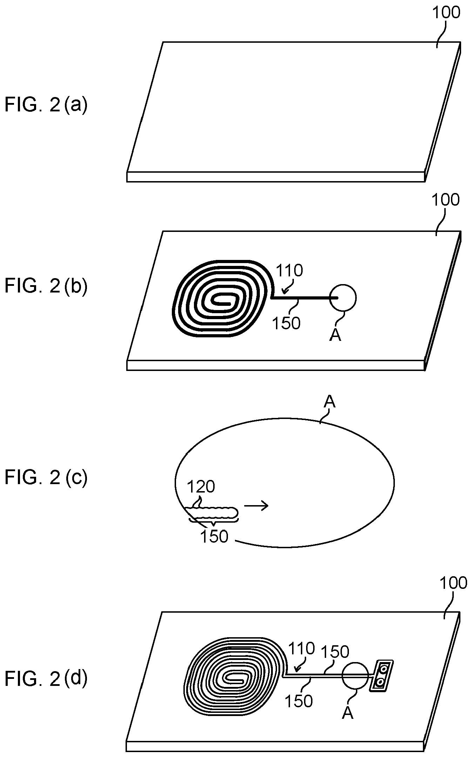

Fig. 1 is an external view of a molded circuit component 300 according to an embodiment of the present invention. Fig. 1 illustrates the molded circuit component 300 including a base material 100 such as a thermoplastic resin or a thermosetting resin, and a metal layer 200 formed in a processing region 110 (Fig. 2(c)) in the base material 100.

Here, an example in which the molded circuit component 300 is used as an antenna is illustrated, but the molded circuit component 300 can realize various electronic circuits in addition to the antenna. In addition, the metal layer 200 can be laid out in a shape corresponding to the application of the molded circuit component 300 and eventually the application of the electronic device including the molded circuit component 300, and the material can also be selected with a high degree of freedom.

Examples of the resin that can be used as the base material 100 include acrylonitrile butadiene styrene (ABS), polycarbonate (PC), polypropylene carbonate (PPC), polyphenylene ether (PPE), modified polyphenylene etheer (m-PPE), liquid crystal polymer (LCP), poly-butyleneterephthalate (PBT), a thermoplastic elastomer (TPE), polyphenylene oxide (PPO), polyetheretherketone (PEEK), and polycyclo hexylene dimethylene eterephthalate (PCT). In the case of a high frequency circuit such as 5G, it is preferable to select a material having a low dielectric loss tangent such as LCP, a cyclic olefin copolymer (COC), syndiotactic polystyrene (SPS), polyacetal (POM), polyimide (PI), or poly tetra fluoro etylene (PTFE).

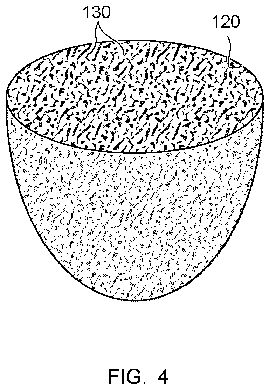

In addition, the base material 100 may be formed by appropriately combining some of the components of the respective resins described above. Alternatively, the base material 100 may further contain a non-conductive filler such as glass fiber in an amount of 5 wt% to 50 wt% with respect to the total weight, or may further contain tin particles, copper particles, antimony particles, or the like in an amount of 5 wt% to 50 wt%. This type of filler and the like can contribute to improving adhesion between the base material 100 and the metal layer 200, similarly to the case of a hole 130 to be described later with reference to Fig. 4.

Furthermore, the material of the base material 100 may be a non-conductor such as fiber, paper, leather, or quartz glass in addition to a resin. That is, the material of the base material 100 can also be selected from materials used for existing base materials as long as it can be used in an electronic circuit.

The metal layer 200 can be formed to have a thickness of, for example, 3 µm to 100 µm. In the present embodiment, the metal layer 200 is formed using a plating method, an ink method, or a spraying method. The metal layer 200 can be made of copper, silver, gold, platinum, nickel, or an alloy thereof. In the present embodiment, an example of employing electroless plating will be described, but electroplating, hot-dip plating, vacuum plating, and the like can also be employed.

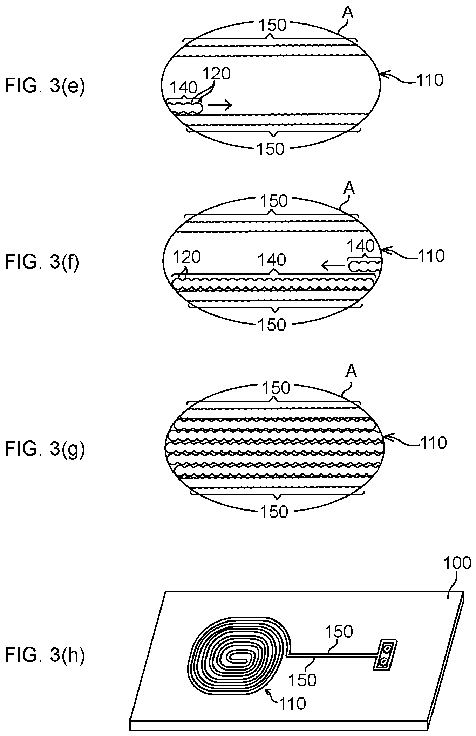

Figs. 2 and 3 are manufacturing process diagrams of the molded circuit component 300 illustrated in Fig. 1.

First, the base material 100 to be processed is prepared (Fig. 2(a)). Here, an example in which the base material 100 is made of a polycarbonate resin for injection molding will be described. As a processing method performed on the base material 100 to form the metal layer 200, laser irradiation, press molding, mold forming, or the like can be employed, but in the present embodiment, an example in which the base material 100 is processed by laser irradiation will be described.

The type of laser is not limited, and lasers of various media such as a solid laser, a liquid laser, a gas laser, a semiconductor laser, and a fiber laser can be used.

Next, by continuously irradiating the base material 100 with a laser, an outline 150 that will be an outer edge of a region where the metal layer 200 is to be formed is formed (Fig. 2(b)). The condition of laser irradiation may be appropriately selected according to the hardness of the base material 100, the application of the molded circuit component 300, and the like, but as an example, the condition may be configured such that the diameter of the bottom surface portion of a recess 120 constituting the outline 150 is approximately 10 µm to 100 µm and the height thereof is 2 µm to 30 µm.

Specifically, the condition of laser irradiation may be a wavelength of 355 nm to 2000 nm (for example, 1064 nm), a lens aperture of 100 mm to 420 mm (for example, 254 mm), a maximum output of 10 W to 30 W (for example, 20 W), a pulse of 4 ns to 200 ns, and a frequency of 5 khz to 500 khz. For example, when a polyimide film is used as the base material 100, a wavelength of 532 nm can be employed, and for example, when a transparent polycarbonate is used as the base material 100, a wavelength of 355 nm can be employed.

When the base material 100 is irradiated with a laser, the irradiated spot (and the vicinity thereof) is dissolved by laser heat. Therefore, a recess 120 is formed in the laser spot on the base material 100. When the first recess 120 is formed, the base material 100 and the laser irradiation device are moved in a line at a relative moving speed of 300 mm/sec to 2500 mm/sec to form a recess 120 adjacent to the corresponding recess 120.

The recess 120 has substantially a dome shape, but may have substantially a conical shape or substantially a pyramid shape in addition to the substantial dome shape. In addition, as the moving speed between the base material 100 and the laser irradiation device becomes slower, the distance between the centers of the recesses 120 adjacent to each other becomes shorter and a shape of the recess 120 is like a U-shaped groove, and when press molding, mold forming, or the like is employed, a shape of the recess 120 can be a V-shaped groove. Therefore, the term "recess" used in the present specification includes like a U-shaped groove, a V-shaped groove, and the like.

Furthermore, focusing on the recess 120 constituting the outline 150 and the recess 120 adjacent thereto, the laser is emitted at a relatively fine pitch such that, for example, 50% to 90% of the areas of the substantially circular bottom surfaces overlap each other. In general, as the heat-resistant temperature of the base material 100 is higher, the overlapping ratio of the recesses 120 adjacent to each other may be increased, and for this purpose, the output of the laser may be increased.

Fig. 2(c) illustrates an enlarged view of a region A illustrated in Fig. 2(b). In Fig. 2(c), an arrow indicating a direction in which the recess 120 is formed is also added. As illustrated in Fig. 2(c), the recesses 120 adjacent to each other overlap to a considerable extent. Therefore, focusing on the recess 120 immediately after formation, there is a boundary line defining the bottom surface of the recess 120 on the front side (right side in the drawing) of the arrow, but the boundary line defining the bottom surface of the recess 120 has already dissolved and is not present on the original side (left side in the drawing) of the arrow.

Thereafter, the portion where the outline 150 is desired to be formed is continuously irradiated with laser to complete the outline 150 (Fig. 2 (d)). Since the outline 150 is the outer edge of the region where the metal layer 200 is to be formed as described above, the region closed by the outline 150 is the processing region 110.

Although it depends on the application and scale of the molded circuit component 300, the processing region 110 having a linear shape is formed, for example, with a width in a range of 20 µm to 200 µm and a maximum depth in a range of 2 µm to 30 µm. That is, in the processing region 110, the ratio between the width and the maximum depth is 10:1 to 6:1.

Hereinafter, in order to describe the processing mode in the processing region 110 in detail, the description will spend some time focusing on the enlarged portion of the region A.

After the formation of the outline 150 is completed, laser irradiation is started on the entire processing region 110. In the present embodiment, laser irradiation is continuously and linearly performed in the processing region 110. The continuous recess 120 thus formed is referred to as a hatch line 140.

The laser irradiation condition for forming the hatch line 140 may be the same as in the case of forming the outline 150, but in order to improve the adhesion between the base material 100 and the metal layer 200, the recesses 120 adjacent to each other in the hatch line 140 are irradiated with the laser at a relatively coarse pitch such that the recesses do not overlap each other or 20% or less of the recesses overlap each other in terms of the areas of the bottom surfaces (Fig. 3(e)).

Here, a state is illustrated in which the recesses 120 adjacent to each other in the hatch line 140 overlap each other by about 10%. However, even if the laser is applied under the condition that the bottom surfaces of the recesses 120 adjacent to each other in the hatch line 140 do not overlap, the region between the recesses 120 is also dissolved by the laser irradiation, and the processing itself is performed in most cases.

Note that, although Fig. 3(e) illustrates the hatch line 140 of the first row not overlapping the outline 150, the recess 120 in the hatch line 140 may be formed to overlap the outline 150.

Subsequently, when the recess 120 is formed in the hatch line 140, the hatch line 140 of the first row is then completed. In the present embodiment, when the hatch line 140 of the first row is completed, the hatch line 140 of the third row is formed with an interval corresponding to one row of the hatch line 140 (Fig. 3(f)).

That is, in the present embodiment, the hatch line 140 of the third row is formed prior to the formation of the hatch line 140 of the second row. Note that the distance between the centers of the hatch lines 140 adjacent to each other can be set to 0.01 mm to 0.2 mm.

In the present embodiment, in this manner, the hatch lines 140 of the odd-numbered rows are formed, and then the hatch lines 140 of the even-numbered rows are formed. In this way, the recess 120 is not formed in the region having a relatively high temperature immediately after dissolution, and deformation of the shape of the subsequently formed recess 120 can be avoided. In particular, it is effective when a thermoplastic resin is selected as the material of the base material 100.

However, in a case where the hatch line 140 is relatively long or the like, the dissolved portion is cooled by the outside air, and thus it is not always necessary to form the hatch line 140 of the odd-numbered rows and then form the hatch line 140 of the even-numbered rows.

Subsequently, when the recess 120 is formed in the hatch line 140, the hatch lines 140 of all rows are formed (Fig. 3(g)). Thereafter, although not illustrated, for example, the hatch line 140 of the first column is formed in a direction orthogonal to the hatch line 140 of each row, then, for example, the hatch lines 140 of the odd-numbered columns, such as the third column and the fifth column, are formed, and then the hatch lines 140 of the even-numbered columns are formed.

In this way, when the hatch lines 140 of all rows and all columns are formed, the plurality of recesses 10 are entirely formed in the processing region 110, and the processing treatment is completed (Fig. 3(h)). However, it is not essential to form the hatch lines 140 in mutually different directions such as the row direction and the column direction, and the hatch lines 140 can be formed only in one direction, that is, the hatch lines 140 can be formed only in the row direction.

In this case, the distance between the centers of the recesses 120 adjacent to each other in the matrix direction may be set to be substantially the diameter of the recess 120, or the bottom surfaces of the recesses 120 adjacent to each other in the matrix direction may overlap each other by about 5% to 15%.

Note that, just to be sure, the outline 150 and the hatch line 140 are not limited to those formed linearly, and include those formed in a curved shape. Specifically, as illustrated in Fig. 3(h), since the processing region 110 also includes a spiral portion, the outline 150 and the hatch line 140 formed in the spiral portion are curved.

In the present embodiment, Figs. 3(e) and 3(f) illustrate an example in which the hatch lines 140 of each row are formed in parallel to the outline 150, but the forming direction of each hatch line 140 does not need to be in a direction parallel to the outline 150.

Therefore, for example, the hatch line 140 of each row may be formed in a direction forming a required angle, for example, 30°, 45°, 60°, or 90°, with respect to the extending direction of the outline 150, and the hatch line 140 of each column may also be formed in a direction forming a required angle, for example, 30°, 45°, 60°, or 90°, with respect to the hatch line of each row.

In addition, instead of each of the hatch lines 140 being formed in such a manner that the plurality of recesses 120 are orthogonal to each other like a matrix, the hatch lines 140 may be formed, for example, in such a manner that the plurality of recesses 120 are arranged in a zigzag manner or a honeycomb manner.

When the laser treatment on the base material 100 is completed, a part of the base material 100 separated at the time of dissolution into particles is attached to the surface of the base material 100. Therefore, for example, particles are removed from the base material 100 by cleaning the base material 100 using an ultrasonic cleaner or irradiating the base material 100 with air using an air gun.

Fig. 4 is an explanatory view of forming the metal layer 200 with a high degree of adhesion to the base material 100 illustrated in Fig. 1. As illustrated in Fig. 4, the recess 120 has a plurality of holes 130 having an irregular shape. Each hole 130 is formed by dissolving when laser irradiation is performed to form the recess 120.

In the present embodiment, prior to forming the metal layer 200 on the base material 100, pretreatment described below is performed. In one step of this pretreatment, a catalyst corresponding to the plating material that will form the metal layer 200 is attached to each hole 130 as well as the recess 120.

Therefore, the metal layer 200 is formed by reacting with the catalyst attached to the recess 120 and each hole 130 and laminating the plating material. However, even if stress is applied to the completed metal layer 200 in the peeling direction, an anchor effect is obtained by each hole 130 having an irregular shape, and the metal layer 200 is not easily peeled off the base material 100.

That is, in the present embodiment, the recess 120 is formed under the condition that each hole 130 having an irregular shape is generated, and the anchor effect is exerted by the shape of the hole 130, so that the metal layer 200 with a high degree of adhesion to the base material 100 is obtained.

Therefore, when the method of forming the recess 120 by laser irradiation is not employed, that is, when the method of forming the recess 120 by press molding or mold forming is employed, molds having shapes corresponding to the recess and the hole are used so that portions corresponding to the recess 120 and the hole 130 can be formed.

Next, pretreatment for forming the metal layer 200 on the base material 100 will be described. The pretreatment varies depending on the materials of the base material 100 and the metal layer 200, but here, a typical example in a case where the material of the metal layer 200 is nickel-copper will be described. The pretreatment includes a surface treatment, a neutralization treatment, an attachment treatment, and an activation treatment, which are described below.

In the surface treatment, an alkali etching treatment is performed to roughen the surface of the base material 100. In the surface treatment, the base material 100 is impregnated in a liquid tank containing a mixed solution obtained by adding 1 L of pure water to 200 mL to 400 mL of high-concentration (for example, 98%) sodium hydroxide to make about 1 L, for 1 minute to 20 minutes (for example, 5 minutes). At this time, the temperature of the mixed solution can be, for example, about 50°C to 70°C. Thereafter, the base material 100 is taken out of the liquid tank and washed pure.

In the neutralization treatment, the alkali state of the surface of the base material 100 is neutralized using an acid. In the neutralization treatment, for example, the base material 100 is impregnated in a liquid tank containing a mixed solution obtained by adding 1 L of pure water to 50 mL to 200 mL of hydrochloric acid having a concentration of 35% to make about 1 L, for example, for 1 minute to 5 minutes. At this time, the temperature of the mixed solution can be, for example, about 10°C to 25°C. Thereafter, the base material 100 is taken out of the liquid tank and washed pure.

In the attachment treatment, a catalyst corresponding to a metal to be laminated is attached by plating to the base material 100. In the attachment treatment, for example, the base material 100 is impregnated in a liquid tank containing a mixed solution obtained by adding 1 L of pure water to 3 mL to 10 mL of tin, 5 mL to 15 mL of hydrochloric acid, and 30 mL to 150 mL of palladium sulfate to make about 1 L, for example, for 1 minute to 10 minutes. At this time, the temperature of the mixed solution can be, for example, about 10°C to 25°C. Thereafter, the base material 100 is taken out of the liquid tank and washed pure.

Alternatively, in the attachment treatment, for example, the base material 100 is impregnated in a liquid tank containing a mixed solution obtained by adding 1 L of pure water to 60 mL to 200 mL of tin, 150 mL to 300 mL of hydrochloric acid, and 10 mL to 450 mL of palladium chloride to make about 1 L, for example, for 1 minute to 10 minutes. At this time, the temperature of the mixed solution can be, for example, about 10°C to 25°C. Thereafter, the base material 100 may be taken out of the liquid tank and washed pure.

In the activation treatment, the catalyst attached to the base material 100 is activated. In the activation treatment, for example, the base material 100 is impregnated in a liquid tank containing a mixed solution obtained by adding 1 L of pure water to 10 mL to 50 mL of hydrochloric acid, 10 mL to 50 mL of hydrogen peroxide, and 30 mL to 100 mL of sulfuric acid to make about 1 L, for example, for several seconds to 10 minutes. At this time, the temperature of the mixed solution can be, for example, about 10°C to 25°C. Thereafter, the base material 100 is taken out of the liquid tank and washed pure.

Next, an electroless plating treatment will be described with a case where the metal layer 200 is a copper layer as an example. The electroless plating treatment includes a strike plating treatment, a copper plating treatment, a nickel plating treatment, a post-treatment, and a drying treatment, which are described below.

In the strike plating treatment, the base material 100 is impregnated in a liquid tank in which 1 L of pure water is added to 300 mL to 350 mL of a required electroless nickel boron strike plating solution to make about 1 L, and adjustment is performed so that a pH is 6.3 to 6.8, for example, for several seconds to 10 minutes. At this time, the temperature of the mixed solution can be, for example, about 50°C to 70°C. Thereafter, the base material 100 is taken out of the liquid tank and washed pure. Note that the strike plating treatment is not always necessary.

As the electroless nickel boron strike plating solution, for example, a mixed solution diluted with pure water to have content ratios of monoethanolamine of 6% to 10%, nickel sulfate of 25% to 35%, ammonia of 1% to 10%, and hypophosphorous acid of 10% to 20% can be used.

In the copper plating treatment, the base material 100 is impregnated in a liquid tank containing a mixed solution obtained by adding 1 L of pure water to 220 mL to 270 mL of a required electroless copper plating solution to make about 1 L, for example, for 2 hours to 3 hours. At this time, the temperature of the mixed solution can be, for example, about 40°C to 55°C. Thereafter, the base material 100 is taken out of the liquid tank and washed pure.

As the electroless copper plating solution, for example, a mixed solution diluted with pure water to have content ratios of 40% to 50% of sodium hydroxide and 6% to 12% of copper sulfate can be used.

In the nickel plating treatment, the base material 100 is impregnated in a liquid tank in which 1 L of pure water is added to 120 mL to 170 mL of a required electroless nickel plating solution to make about 1 L, and adjustment is performed so that a pH is 6.0 to 6.7, for example, for several seconds to 10 minutes. At this time, the temperature of the mixed solution can be, for example, about 40°C to 55°C. Thereafter, the base material 100 is taken out of the liquid tank and washed pure.

As the electroless nickel plating solution, for example, a mixed solution diluted with pure water to have content ratios of lactic acid of 10%, sodium hydroxide of 4%, nickel sulfate of 45%, sodium phosphate of 20%, sodium hydroxide of 4.5%, and malic acid of 3% can be used.

In the post-treatment, the base material 100 is impregnated in a liquid tank containing a mixed solution obtained by adding 1 L of pure water to 50 mL to 100 mL of a required post-treatment liquid to make about 1 L, for example, for 30 seconds to 2 minutes. At this time, the temperature of the mixed solution can be, for example, about 30°C to 70°C. Thereafter, the base material 100 is taken out of the liquid tank and washed pure.

In the drying treatment, the base material 100 is carried into a dryer (not illustrated) and dried at a temperature of 50°C to 100°C for 15 minutes to 60 minutes.

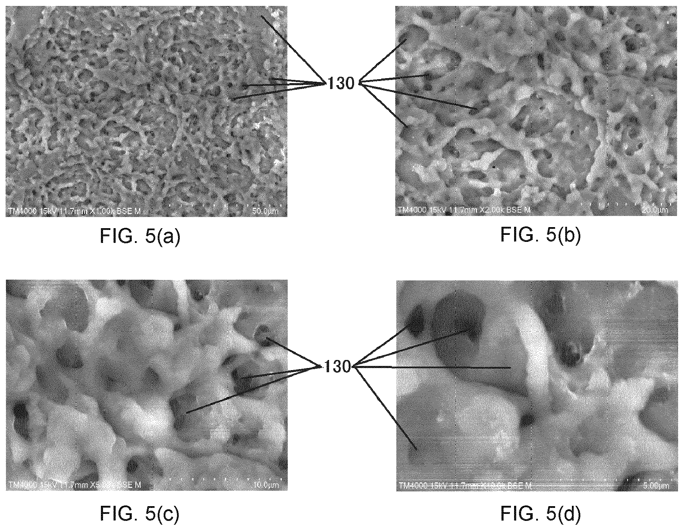

Fig. 5 is SEM photographs of a side surface of the recess 120 constituting the hatch line 140 illustrated in Fig. 3(e). Fig. 5(a) illustrates a photograph enlarged 1000 times, Fig. 5(b) illustrates a photograph enlarged 2000 times, Fig. 5(c) illustrates a photograph enlarged 5000 times, and Fig. 5(d) illustrates a photograph enlarged 10000 times.

As illustrated in Figs. 5(a) to 5(d), it can be seen that a plurality of holes 130 are formed in the side surface of the recess 120. Since the shapes of the holes 130 are irregular, the sizes are also irregular, but there are many holes having an opening size of approximately 10 µm to 30 µm.

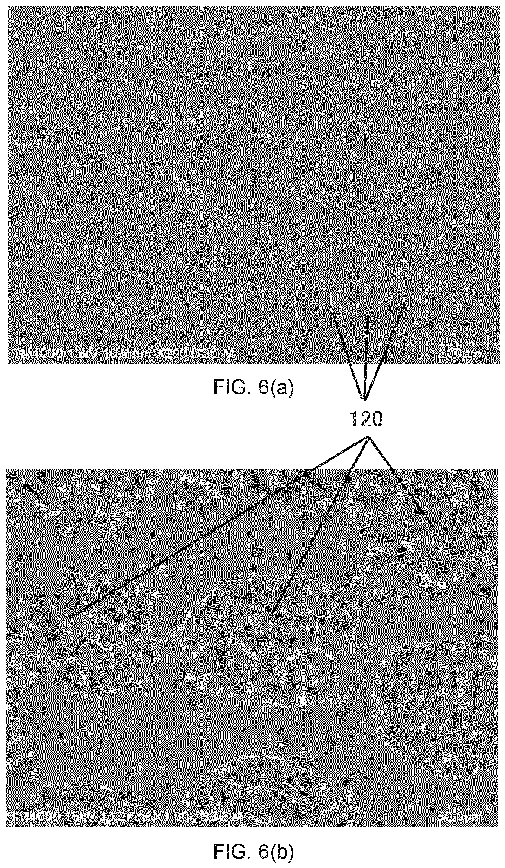

Fig. 6 is SEM photographs illustrating a plane of the processing region 110 illustrated in Fig. 3(g). Fig. 6(a) illustrates a photograph enlarged 200 times, and Fig. 6(b) illustrates a photograph enlarged 1000 times. Here, the recesses 120 adjacent to each other are basically formed so as not to overlap each other.

As illustrated in Figs. 6(a) and 6(b), recesses 120 are formed in a matrix in the processing region 110. Even if the laser irradiation is performed according to the condition, microscopically, it is difficult to form recesses 120 regularly according to the condition, but it can be seen that recesses 120 of about 400 µm are formed.

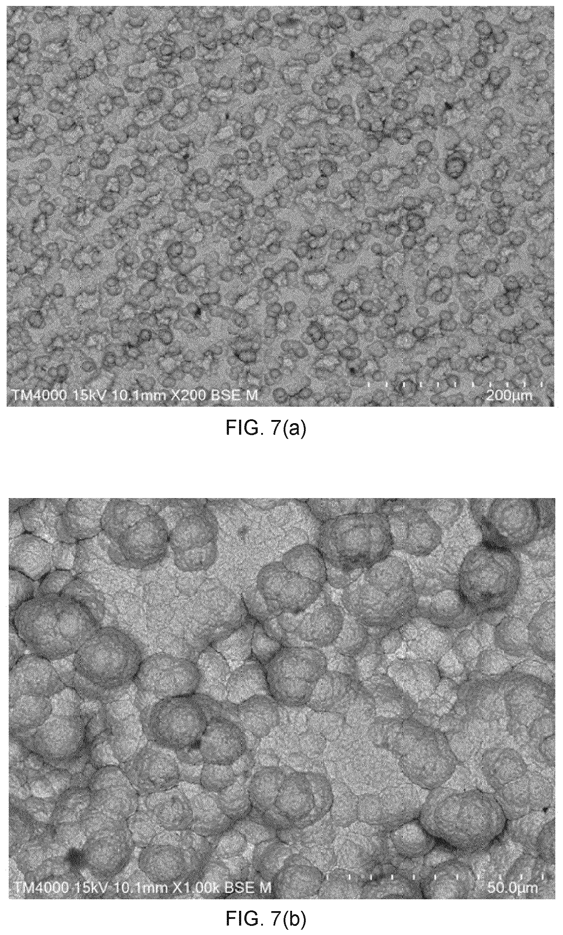

Figs. 7(a) and 7(b) are SEM photographs illustrating a plane of the metal layer 200 of Fig. 1. Fig. 7(a) illustrates a photograph enlarged 200 times, and Fig. 7(b) illustrates a photograph enlarged 500 times. As illustrated in Figs. 7(a) and 7(b), it can be seen that the metal layer 200 is formed entirely on the surface of the processing region 110 of the base material 100.

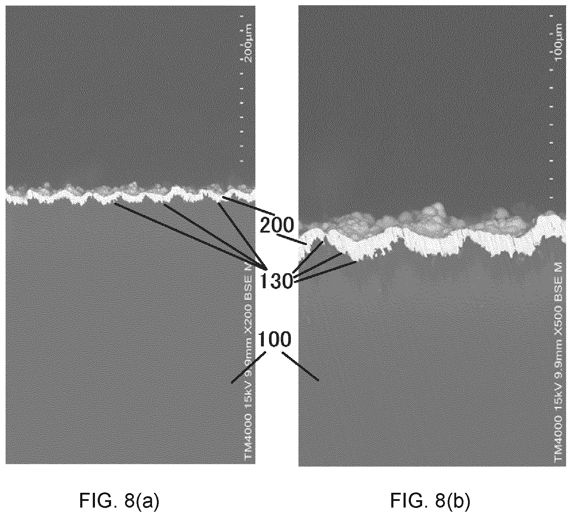

Figs. 8(a) and 8(b) are SEM photographs illustrating a cross section of the metal layer 200 in Fig. 1. Fig. 8(a) illustrates a photograph enlarged 200 times, and Fig. 8(b) illustrates a photograph enlarged 500 times. In Figs. 8(a) and 8(b), it can be seen that substantially dome-shaped recesses 120 are continuously formed downward at a pitch of about 400 µm with no interval. In order to obtain the cross-sectional photograph described in the present specification, the base material 100 was cut using a polishing machine FG-18 manufactured by RYOBI LIMITED.

In addition, in each of the recesses 120, visually, it can be seen that a plurality of holes 130 are present in a spine shape in the radial direction with respect to the surfaces. Since the metal layer 200 is located in each hole 130, it can be seen that the metal layer 200 and the base material 100 are firmly connected.

As described above, according to the molded circuit component 300 of the present embodiment, the metal layer 200 can be formed with high adhesion by giving a degree of freedom to the base material 100. Therefore, the molded circuit component 300 can be used in various electronic circuits such as electrical appliances, communication terminals, adapters for memory cards, optical receptacles, optical element blocks, electrical connectors, and automobiles.

## Claims

1. A molded circuit component comprising a metal layer formed in a processing region in a base material,
wherein a plurality of recesses each having a plurality of holes are continuously formed in the processing region.

2. The molded circuit component according to claim 1, wherein the processing region has a ratio of a width to a maximum depth with respect to a surface of the base material of 10:1 to 6:1.

3. The molded circuit component according to claim 1, wherein the processing region is formed to have a width in a range of 20 µm to 200 µm, and formed to have a maximum depth with respect to the surface of the base material in a range of 2 µm to 30 µm.

4. The molded circuit component according to claim 1, wherein the metal layer is formed in the processing region by laminating using a plating method, and
a catalyst that reacts with a metal that forms the metal layer at the time of the lamination is attached to the holes and the recesses.

5. The molded circuit component according to claim 1, wherein a distance between centers of recesses adjacent to each other among the plurality of recesses is 0.01 mm to 0.2 mm.

6. The molded circuit component according to claim 1, wherein no metal material is contained in the base material.

7. An electronic device comprising the molded circuit component according to claim 1.
